# EUROPEAN PATENT APPLICATION

(11) **EP 0 997 995 A1**
(43) Date of publication of application: **03.05.2000**
(21) Application number: 99121246.5
(22) Date of filing: 25.10.1999
(51) Int. Cl.: H01S 5/227

(54) **Fabrication method of semiconductor laser**

(30) Priority: 26.10.1998 JP 30428598
(71) Applicant: NEC CORPORATION, Tokyo (JP)
(72) Inventor: Sasaki, Yoshihiro, Minato-ku, Tokyo (JP); Okunuki, Yuichiro, Minato-ku, Tokyo (JP)
(74) Representative: Glawe, Delfs, Moll & Partner

(57) **Abstract**

A fabrication method for fabricating a semiconductor laser, which can improve the product yield by reliably removing a silicon oxide film deposited on a sidewall of a mesa shaped optical waveguide formed on a semiconductor substrate while reliably forming a silicon oxide film on an upper surface of the optical waveguide to lower the possibility of fabrication of semiconductor lasers having defective characteristics possibly caused by subsequent fabrication steps, is disclosed. After the optical waveguide is formed on the semiconductor substrate, a silicon oxide film is deposited on a whole surface of the wafer and, then, the silicon oxide film deposited on the whole surface of the wafer is etched to selectively remove the silicon oxide film on the sidewall of the optical waveguide . The formation of the silicon oxide film and the etching thereof are repeated at least twice successively. The formation of the silicon oxide film may be performed while applying a bias voltage to the semiconductor substrate. Alternatively, the formation of the silicon oxide film may be performed by depositing a silicon oxide film without application of a bias voltage to the semiconductor substrate and further depositing a silicon oxide film thereon while applying the bias voltage thereto.

## Description

### BACKGROUND OF THE INVENTION

### Field of the Invention

The present invention relates to a fabrication method of a semiconductor laser used in the field of optical communication or optical information processing, etc. Particularly, the present invention relates to a method for forming a mask for blocking a growth of a current block layer on a mesa shaped optical waveguide of a semiconductor laser.

### Description of the Related Art

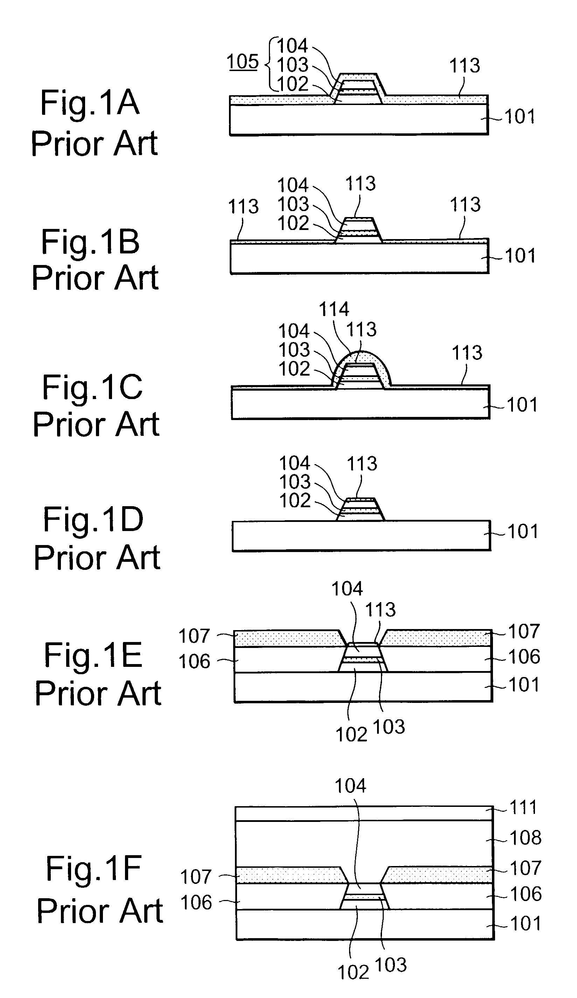

Japanese Patent Application Laid-open No. Hei 10-117038 discloses a conventional fabrication method of a semiconductor laser. The disclosed fabrication method will be described briefly with reference to Figs. 1A to 1F.

as shown in Fig. 1A, a mesa shaped optical waveguide (referred to as "mesa structure" as the case may be) 105 including a clad layer 102, an active layer 103 and a clad layer 104 is formed on a semiconductor substrate 101 and an insulating film 113 of silicon oxide is formed on a whole surface of the wafer. Then, as shown in Fig. 1B, only portions of the insulating film 113, which are on sidewalls of the mesa structure 105, are completely removed by chemical etching. Thereafter, a resist film 114 is formed to cover the whole mesa structure 105 and, then, an exposed portion of the insulating film 113 is removed, as shown in Fig. 1C. In this case, portions of the insulating film 113, which are covered by the resist film 114, are also removed by side etching. Then, as shown in Fig. 1D, the resist film 114 is removed, leaving the insulating film 113 on an upper surface of the mesa structure 105 as it is.

Thereafter, current block layers 106 and 107 are formed in the order, as shown in Fig. 1E. After the insulating film 113 on the upper surface of the mesa structure is removed, a burying layer 108 is formed thereon and a contact layer 111 is formed on the burying layer 108, as shown in Fig. 1E.

In the method mentioned above, it is necessary, in the step of forming the insulating film 113 shown in Fig. 1A, to make the insulating film portions on the sidewalls of the mesa structure thinner than other portions of the insulating film 113 on the upper surface of the mesa structure and the surface of the semiconductor substrate 101. However, it is difficult to form such insulating film on only the upper surface of the mesa structure.

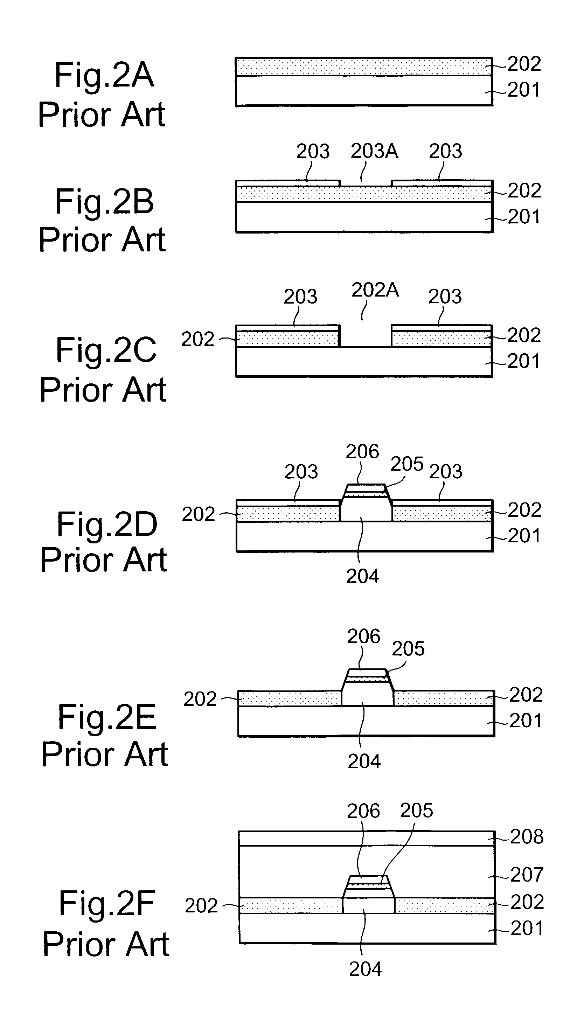

In order to solve the difficulty of forming the insulating film on only the upper surface of the mesa structure of the semiconductor laser, Japanese Patent Application Laid-open No. Hei 10-117038 proposes a fabrication method of a semiconductor laser, which is shown in Figs. 2A to 2F.

According to the proposed method, a high resistance semiconductor layer 202 having a current blocking function is formed on a semiconductor substrate 201 as shown in Fig. 1A. Then, as shown in Fig. 1B, an insulating film 203 having a striped opening 203A is formed on the high resistance semiconductor layer 202. Thereafter, the high resistance semiconductor layer 202 is etched away by using the insulating film 203 as a mask to expose a portion of the semiconductor substrate 201 as shown in Fig. 2C. Then, a mesa structure including a buffer layer 204, an active layer 205 and a clad layer 206 is formed by using the insulating film 203 as a mask, as shown in Fig. 2D. Thereafter, the insulating film 203 is removed to expose the high resistance semiconductor layer 202 as shown in Fig. 2E. On the wafer, a clad layer 207 and a contact layer 208 are formed in the order as shown in Fig. 2F.

That is, according to the proposed method, the high resistance layer having a current blocking function is preliminarily formed on the semiconductor substrate and the mesa structure is formed within the opening portion of the high resistance layer, so that it becomes possible to form the current block layer without forming the insulating film on the upper surface of the mesa structure.

One reason for this is that the thickness of the insulating film formed on the whole surface of the semiconductor substrate may not be uniform. Therefore, when a plurality of mesa structures are formed on the semiconductor substrate, the thickness of the insulating film on the upper surfaces of the mesa structures may become different each other and the thickness of the insulating film on the sidewalls of the mesa structures may be also different each other.

Another reason is that the etching rate for the insulating film on the whole surface of the semiconductor substrate may not be uniform and, therefore, when the silicon oxide film on the sidewall of the mesa structure is completely removed by etching, there may be a case where a portion of the insulating film on the sidewall of the mesa structures is left thereon as residual or the insulating film on the upper surface of the mesa structure disappears.

Considering a case where the insulating film is left on the sidewall of the mesa structure after the etching process shown in Fig. 1B and other portion of the insulating film than that on the upper surface of the mesa structure is etched away by using a photo resist covering the mesa structure as shown in Figs. 1C and 1D, the insulating film on the upper surface of the mesa structure disappears completely by a side etching or, if not disappear completely, only a portion thereof is left thereon.

In the case where the insulating film on the upper surface of the mesa structure disappears completely, the upper surface of the optical waveguide, that is, the mesa structure, may directly contact with a p-InP block layer and an n-InP block layer when these block layers are formed. That is, the n type block layer and the p type bock layer are formed sequentially on the upper surface of the mesa structure, resulting in that a current path strangulating structure composed of a pnpn thyristor. Therefore, current is not injected into the mesa shaped optical waveguide, so that the laser can not oscillate at all.

In the case where the insulating film on the upper surface of the mesa structure is partially left therein, the p-InP layer and the n-InP layer are pushed out on the upper surface of the mesa structure, resulting in that the current path is narrowed and the resistance value thereof is increased. Therefore, the threshold value is increased. That is, although the laser oscillation occurs, the laser radiates heat by the increased resistance value when the laser emits light, resulting in a saturation of optical output.

### SUMMARY OF THE INVENTION

An object of the present invention is to provide a fabrication method of a semiconductor laser, according to which it is possible to reliably form a mask for blocking a growth of a current block layer on an upper surface of each of mesa structures formed on a semiconductor substrate.

Another object of the present invention is to remove characteristics defect of semiconductor laser elements, which may be caused by semiconductor laser forming steps subsequent to the mask forming step to thereby improve the product yield of semiconductor laser.

In order to achieve the above object, a method for fabricating a semiconductor laser according to an aspect of the present invention includes the step of forming a mask for preventing a current blocking layer from growing on an upper surface of a mesa shaped optical waveguide formed on a semiconductor substrate.

According to another aspect of the present invention, the fabrication method for fabricating a semiconductor laser includes the step of reliably depositing a silicon oxide film on an upper surface of a mesa shaped optical waveguide formed on a semiconductor substrate while reliably removing the silicon oxide film on a side wall of the optical waveguide.

According to another aspect of the fabrication method, the fabrication method for fabricating a semiconductor laser includes the step of forming a silicon oxide film such that the thickness of the silicon oxide film on the upper surface of the optical waveguide is larger than the thickness of the silicon oxide film on a side wall of the optical waveguide.

According to another aspect of the present invention, the fabrication method for fabricating a semiconductor laser includes, in order to form a silicon oxide film which becomes a growing blocking mask on an upper surface of a mesa shaped optical waveguide formed on a semiconductor substrate, a first step of depositing a silicon oxide film on a whole surface of the semiconductor substrate, a second step of etching a whole surface of the silicon oxide film and a third step of repeating the first and second steps at least twice. The first step may be referred to as "whole surface film forming step" and the second step may be referred to as "whole surface etching step", as the case may be. In this case, the silicon oxide film may be deposited on the whole surface of the wafer by using thermal CVD and BHF (buffered hydrofluoric acid) etchant may be used to etch the whole surface of the silicon oxide film.

According to another aspect of the present invention, the fabrication method includes, in order to form a silicon oxide film which becomes a growing blocking mask on an upper surface of a mesa shaped optical waveguide formed on a semiconductor substrate, the step of depositing a silicon oxide film on the upper surface of the mesa shaped optical waveguide by depositing the silicon oxide film while applying a bias voltage to the semiconductor substrate, under a condition that the deposition of the silicon oxide film and the etching of the silicon oxide film are performed simultaneously. In this case, an etching rate of the silicon oxide film formed while applying the bias voltage to the semiconductor substrate is higher for the silicon oxide film on the upper surface of the optical waveguide than that for the silicon oxide film on a sidewall of the optical waveguide.

According to another aspect of the present invention, the step of depositing the silicon oxide film on the semiconductor substrate includes the step of depositing a silicon oxide film without application of a bias voltage to the semiconductor substrate and the step of further depositing a silicon oxide film on the previously deposited film, while applying the bias voltage to the semiconductor substrate.

The step of depositing the silicon oxide film may be performed by using plasma CVD including ECR (electron cyclotron resonance) plasma CVD. Alternatively, the step of depositing the silicon oxide film may be performed by using bias-sputtering or ECR sputtering.

In the fabrication method for fabricating the semiconductor laser by depositing a silicon oxide film on the whole surface of the wafer after the mesa shaped optical waveguide is formed on the semiconductor substrate, then etching the silicon oxide film formed on the whole surface of the wafer and repeating the whole surface film forming step and the whole surface etching step at least twice, it is possible to increase the difference in thickness of the silicon oxide film between the upper surface of the optical waveguide, the side wall of the optical waveguide and the flat portion of the semiconductor substrate. Therefore, it is possible, by etching the silicon oxide film having varying thickness, to reliably remove the silicon oxide film on the side wall of the optical waveguide while reliably leaving the silicon oxide film on the upper surface of the optical waveguide.

Further, since the etching rate for the silicon oxide film deposited on the semiconductor substrate while applying a bias voltage thereto is higher for the silicon oxide film on the side wall of the optical guide than that for the silicon oxide film on the upper surface of the optical waveguide and on the flat portion of the semiconductor substrate, the silicon oxide film on the upper surface of the optical waveguide and on the flat portion of the semiconductor substrate becomes thicker than that on the side wall of the optical waveguide. Therefore, when the silicon oxide film deposited on the substrate while applying a bias voltage thereto is etched by using BHF as an etchant, the process margin becomes large, so that it becomes possible to reliably remove the silicon oxide film on the side wall of the optical waveguide while reliably leaving the silicon oxide film on the upper surface of the mesa structure.

Further, since the etching rate for the silicon oxide film deposited on the semiconductor substrate without application of a bias voltage thereto firstly and then with application of the bias voltage thereto is higher for the silicon oxide film on the side wall of the optical waveguide than for the silicon oxide film on the upper surface of the optical waveguide and on the flat portion of the semiconductor substrate, the silicon oxide film on the side wall of the optical waveguide is thinner than that on the upper surface of the optical waveguide and on the flat portion of the semiconductor substrate. Therefore, when the silicon oxide film deposited on the substrate while applying a bias voltage thereto is etched by using BHF as an etchant, the process margin becomes large, so that it becomes possible to reliably remove the silicon oxide film on the side wall of the optical waveguide while reliably leaving the silicon oxide film on the upper surface of the mesa structure.

### BRIEF DESCRIPTION OF DRAWINGS

The above and other objects, advantages and features of the present invention will become more apparent from the following description taken in conjunction with the accompanying drawings, in which:
Figs. 1A to 1F are cross sections of a semiconductor laser, showing fabrication steps of a conventional fabrication method thereof;
Figs. 2A to 2F are cross sections of a semiconductor laser, showing fabrication steps of another conventional fabrication method thereof;
Fig. 3 is a perspective view of a semiconductor laser according to the present invention;
Fig. 4 is a cross section taken along a line X-X' in Fig. 3;
Figs. 5A to 5G are cross sections of a semiconductor laser, showing fabrication steps according to a first embodiment of the present invention;
Fig. 6 is a cross sectional side view of an ECR plasma CVD device to be used in a second embodiment of the present invention;
Figs. 7A to 7D are cross sections of a semiconductor laser, showing fabrication steps according to the second embodiment of the present invention;
Figs. 8A to 8D are cross sections of a semiconductor laser, showing fabrication steps according to a third embodiment of the present invention; and
Fig. 9 shows a structure of a spot size converter integrated laser diode of the present invention.

### DETAILED DESCRIPTION OF THE PREFERRED EMBODIMENTS

The present invention will be described in detail with reference to the accompanying drawings.

### [First Embodiment]

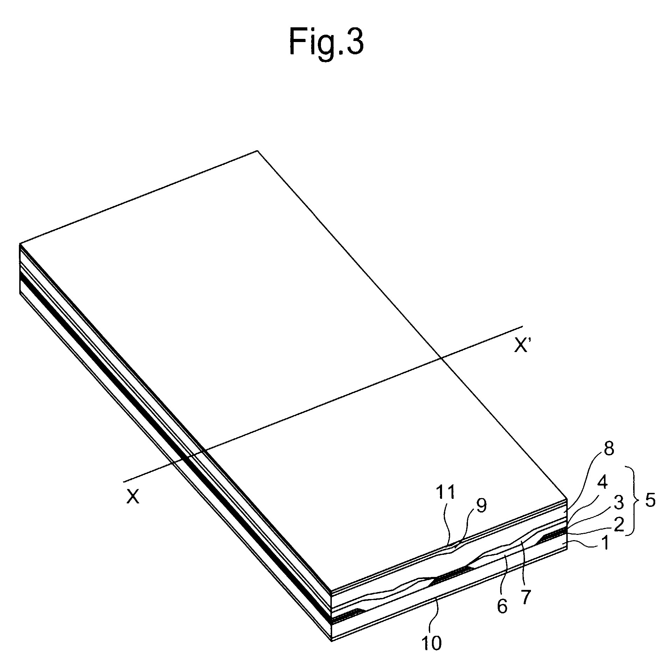

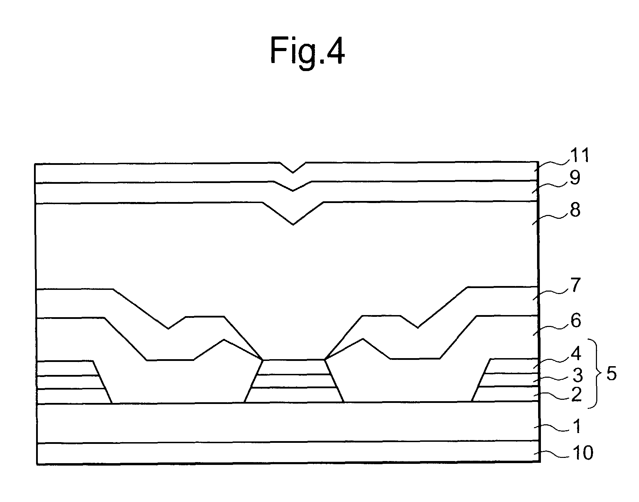

Fig. 3 is a perspective view of a semiconductor laser having a InP burying heterostructure and Fig. 4 is a cross section taken along a line X-X' in Fig. 3.

In Fig. 4, a reference numeral 1 depicts an n-InP substrate, 2 an n-InP clad layer, 3 an MQW (Multiple Quantum Well) active layer having an MQW structure and 4 a p-InP clad layer. The n-InP clad layer 2, the MQW active layer 3 and the p-InP clad layer 4 form a mesa shaped optical waveguide 5. The mesa shaped optical waveguide 5 will be referred to as "mesa optical waveguide" or merely "mesa structure", hereinafter. A reference numeral 6 depicts a p-InP block layer, 7 an n-InP block layer, 8 a p-InP clad layer, 9 a p-InGaAs cap layer, 10 an n type electrode and 11 a p type electrode.

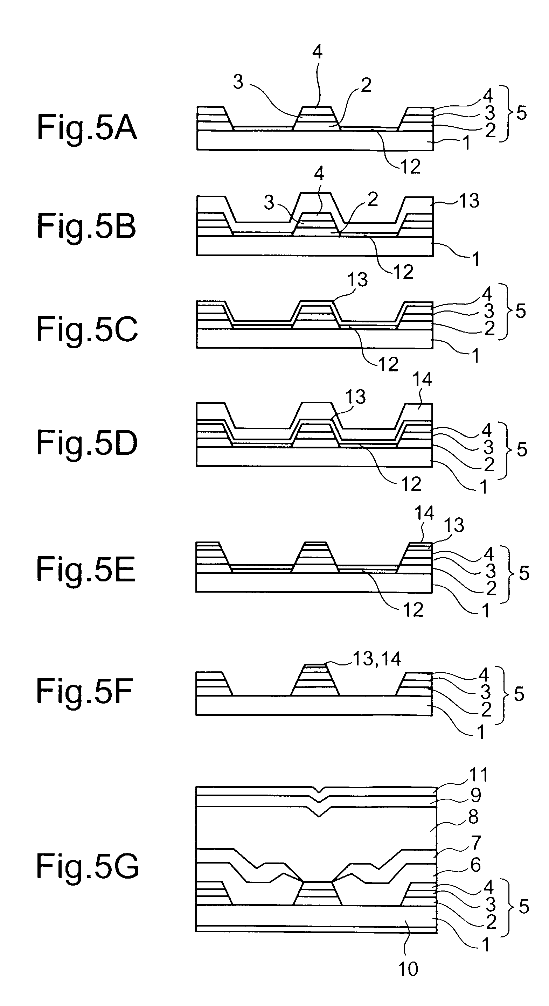

A first embodiment of the present invention, which is a method for reliably forming a silicon oxide film on an upper surface of the mesa optical waveguide 5 by repeating a whole surface film forming step for forming a silicon oxide film on a whole surface of the semiconductor substrate by using thermal CVD and a whole surface etching step for etching the silicon oxide film formed on the whole surface of the substrate at least twice successively, will be described with reference to Figs. 5a to 5G.

The construction of the semiconductor laser formed according to the present invention is shown in Figs. 3 and 4.

First, on a (100) plane of the n-InP substrate 1, a striped silicon oxide mask 12 having growth blocking portions each 5µm wide and opening portions each 1.5µm wide in (011) direction of the n-InP substrate 1 is formed by patterning a silicon oxide film 1000Å thick. Then, the n-InP clad layer 2 (carrier density : 1 x 10¹⁸cm⁻³, film thickness : 150nm), the MQW active layer 3 (film thickness : 150nm) and the p-InP clad layer 4 (carrier density : 7 x 10¹⁸cm⁻³, film thickness : 150nm) are selectively grown in each of the opening portions of the striped silicon oxide mask 12 in the order by MOVPE (metal organic vapor phase epitaxy), to form the mesa optical waveguides 5, as shown in Fig. 5A.

Then, as the first whole surface film forming step, a silicon oxide film 13 is formed on the whole surface of the n-InP substrate 1 by using thermal CVD in such a way that the thickness of the silicon oxide film 13 in flat portions of the n-InP substrate 1, that is, portions thereof having no striped silicon oxide film mask 12 and sufficiently remote from the mesa structure 5, becomes about 4500Å, as shown in Fig. 5B. In this case, the thickness of the silicon oxide film 13 deposited on the upper surface of each mesa structure 5 is 4700Å and that deposited on sidewall thereof is 3800Å measured in the normal direction of the slope of the side wall.

Thereafter, as a first whole surface etching step, the silicon oxide film 13 is etched by using BHF as an etchant, such that the thickness of the silicon oxide film 13 on the flat portion of the n-InP substrate 1 becomes about 700Å, as shown in Fig. 5C. By this first whole surface etching stop, the thickness of the silicon oxide film 13 on the upper surface of the mesa structure 5 becomes about 900Å and that on the side wall comes about 100Å.

Then, as a second whole surface film forming step, a silicon oxide film is formed on the whole surface of the n-InP substrate 1 by using thermal CVD in such a way that the thickness of the silicon oxide film 1 in the flat portions of the n-InP substrate 1 becomes about 4500Å, as shown in Fig. 51). In this case, a total thickness of the silicon oxide film 13 and the silicon oxide film 1-1 deposited on the flat portion of the n-InP substrate 1 becomes 5200Å. As a result, a total thickness of the silicon oxide films 13 and 14 on the upper surface of each mesa structure 5 becomes 5800Å and that deposited on the sidewall thereof becomes 3900Å.

Thereafter, as a second whole surface etching step, the silicon oxide film is etched away by using BHF as the etchant such that a total thickness of the striped silicon oxide film mask 12 and the silicon oxide films 13 and 14 on the flat portion of the n-InP substrate 1 becomes about 500Å, as shown in Fig. 5E. By this second whole surface etching step, the silicon oxide films 13 and 14 on the sidewalls of the mesa structure 5 are removed completely while a silicon oxide film 1100Å thick in total is left on the upper surface of the mesa structure 5.

Thickness ratio of the silicon oxide film on the upper surface of the mesa structure 5 to that on the side wall thereof before the second whole surface etching step is about 3 : 2 since (upper surface of the mesa 5) : (side wall of the mesa structure 5) = 5800 : 3900. By setting the thickness of the silicon oxide film on the surface of the mesa structure 5 at least 1.5 times that on the side wall of the mesa structure 5, it is possible to completely remove the silicon oxide film on the side wall of the mesa structure 5 by the second whole surface etching step, while reliably leaves the silicon oxide film on the upper surface of the mesa structure 5.

Even in a case where a wet etching is performed by using other etchant than BHF as the second whole surface etching step, it is possible to completely remove the silicon oxide film on the sidewall of the mesa structure while reliably leaving the silicon oxide film on the upper surface of the mesa structure 5 as in the case of the wet etching using BHF so long as the thickness of the silicon oxide film on the upper surface of the mesa structure 5 is set at least 1.5 times that on the sidewall of the mesa structure 5. This is because the etching rate of other etchant than BHF for the silicon oxide film on the upper surface of the mesa structure is the same as that for the silicon oxide film on the sidewall thereof.

Then, the silicon oxide film on the n-InP substrate 1 is removed, while leaving only the silicon oxide film on the upper surface of the mesa structure 5, through the steps similar to those shown in Figs. 1C and 1D, resulting in a structure shown in Fig. 5F. That is, a photo resist covering the mesa structure 5 is formed as shown in Fig. 1C and, then, the exposed portion of the silicon oxide film is etched away as shown in Fig. 1D. In this case, the portions of the silicon oxide film formed on the n-InP substrate 1, which are below the photo resist, are removed by side etching.

Then, as shown in Fig. 5G, the p-InP block layer 6 (carrier density : 7 x 10¹⁷cm⁻³, film thickness : 600nm) and the p-InP block layer 7 (carrier density : 7 x 10¹⁸cm⁻³, film thickness : 600nm) are selectively grown by MOVPE. In this case, the silicon oxide films 13 and 14 on the upper surface of the mesa structure 5 function as a mask for preventing the p-InP block layer 6 and the n-InP block layer 7 from growing on the surface of the mesa structure 5.

Then, after the silicon oxide film 13 on the upper surface of the mesa structure 5 is removed, the p-InP clad layer 8 (carrier density : 1 x 10¹⁸cm⁻³, film thickness : 2µm) and the p-InGaAs cap layer 9 (carrier density : 5 x 10¹⁸cm⁻³ film thickness : 0.2µm) are grown in the order to bury the mesa structure 5.

Finally, the n-side electrode 10 and the p-side electrode 11 are formed on the lower surface of the n-InP substrate 1 and on the p-InGaAs cap layer 9, respectively resulting in the semiconductor laser shown in Fig. 4.

In the above described method, in which the whole surface film forming step with using thermal CVD and the subsequent whole surface etching step with using BHF as the etchant are repeated at least twice, the portions of the silicon oxide film 13 formed on the upper surface of the mesa structure 5, on the sidewall thereof and on the flat portion of the n-InP substrate 1 by the whole surface film forming step are different in thickness each other. Further, the portions of the silicon oxide film 14 formed on the upper surface of the mesa structure 5, on the sidewall thereof and on the flat portion of the n-InP substrate 1 by the whole surface film forming step are also different in thickness each other. As a result, the difference in total thickness of the silicon oxide films 13 and 14 on the upper surface of the mesa structure 5, on the sidewall thereof and on the flat portion of the n-InP substrate 1 becomes larger by repeating the whole surface film forming step and the whole surface etching step at least twice. Therefore, it is possible, by the whole surface etching step, to reliably remove the silicon oxide films 13 and 14 on the side wall of the mesa structure 5 while reliably leaving the silicon oxide film 13 on only the upper surface of the mesa structure 5.

The use of thermal CVD in this embodiment is advantageous in that the thermal CVD device is simple and advantageous in fabrication cost of semiconductor laser and that it is possible to make the thickness of silicon oxide film deposited on an underlying flat portion different from that deposited on a sloped portion. That is, it is possible to effectively provide a difference in thickness between, the silicon oxide film on the upper surface of the mesa structure and the silicon oxide film on the sidewall thereof by using thermal CVD.

In thermal CVD, material elements are fallen down to and deposited on the surface of the substrate. Therefore, the thickness of the silicon oxide film deposited on the side wall of the mesa structure is (cos θ) times that of the upper surface of the mesa structure where θ is an angle between the surface of the sloped side wall and the surface of the semiconductor substrate. Thus, it is possible to make the thickness of the silicon oxide film deposited on the sidewall of the mesa structure smaller than that of the silicon oxide film deposited on the upper surface of the mesa structure, by using thermal CVD.

In the first whole surface etching step of the first embodiment, the silicon oxide film 13 on the flat portion of the n-InP substrate 1 is etched until the thickness thereof becomes about 700Å, while leaving the silicon oxide film 13 about 100Å thick on the sidewall of the mesa structure 5. However, it is possible, in the first whole surface etching step, to etch the silicon oxide film 13 on the flat portion of the n-lnP substrate 1 until the thickness thereof becomes about 300Å to thereby completely remove the silicon oxide film 13 on the sidewall of the mesa structure 5. In the latter case, the thickness of the silicon oxide film 13 on the upper surface of the mesa structure 5 becomes about 500Å. Thereafter, the second whole surface-etching step is performed.

The feature of the present invention is that the whole surface film forming step with using thermal CVD and the whole surface etching step wit using BHF as the etchant are repeated at least twice. In the first embodiment, after the silicon oxide film 4700Å thick and the silicon oxide film 3800Å thick are deposited on the upper surface of the mesa structure and on the side wall thereof, respectively, in the first whole surface film forming step and the subsequent first whole surface etching stop is performed, the silicon oxide film 5800Å thick and the silicon oxide film 3900Å thick are deposited on the upper surface of the mesa structure and on the side wall thereof, respectively, in the second whole surface film forming step. The reason for providing the etching step between the first and second whole surface film forming steps will be described. Since the height of the mesa structure is 4500Å and the growth blocking width of the striped silicon oxide mask 12 is 5µm, a groove between the active layer and an SSC (spot size converter) portion is buried by silicon oxide when the silicon oxide film is continuously deposited without the etching step, so that the difference in thickness between the silicon oxide films on the side wall of the mesa structure and on the upper surface thereof disappears. Therefore, the etching step is provided between the two whole surface forming steps so that the silicon oxide film on the sidewall of the mesa structure can be distinguished from that on the upper surface of the mesa structure.

The variation of thickness of the firstly formed silicon oxide film 13 in the plane of the substrate is proportional to the thickness of the same silicon oxide film 13. Therefore, the thickness of the silicon oxide film 13 formed in the first whole surface film forming step after the mesa structure is formed is made as small as about 1000Å and, subsequently, the same silicon oxide film 13 on the flat surface portion of the n-InP substrate 1 is etched to 500Å in the first whole surface etching step. These steps are repeated so that the variation of thickness of the silicon oxide film 13 throughout the wafer can be restricted.

By reliably leaving the silicon oxide film on the upper surface of the mesa structure in this manner, it is possible to prevent the p-InP block layer 6 and the n-InP block layer 7 from growing on the upper surface of the mesa structure 5 in the growing step of these block layers. Therefore, it is possible to reduce the possibility of degradation of the current-voltage characteristics of the semiconductor laser to thereby improve the uniformity of various element characteristics of the semiconductor laser. Consequently, when a plurality of semiconductor lasers are formed on the n-InP substrate, the product yield can be improved.

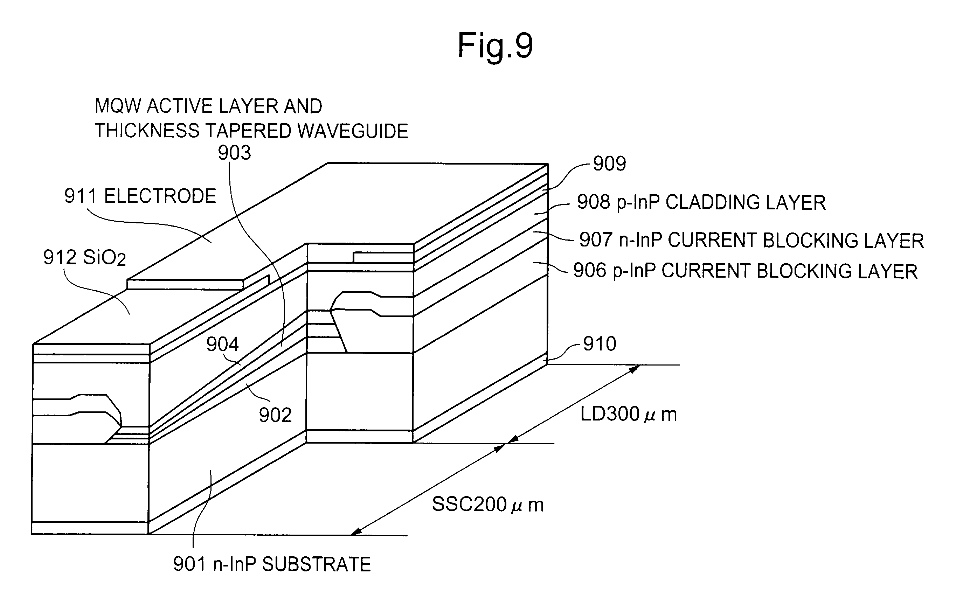

The above described method can be applied to a fabrication method of such semiconductor laser having a mesa structure whose height is not constant as an SSCLD (spot size converter integrated laser diode) which has a mesa structure composed of a laser oscillator portion and a spot size converter portion connected thereto. Fig. 9 shows an SSCLD fabricated according to the present invention.

Since the difference in thickness of the silicon oxide film 13 formed by thermal CVD increases with increase of the height of the mesa structure, it is possible to reliably form the silicon oxide film 13 on the upper surface of the mesa structure in the resonator direction of the SSCLD.

### [Second Embodiment]

A second embodiment of the present invention will be described. According to the second embodiment, ECR plasma CVD is used to deposit the silicon oxide film on an upper surface of a mesa structure 5 of a semiconductor laser.

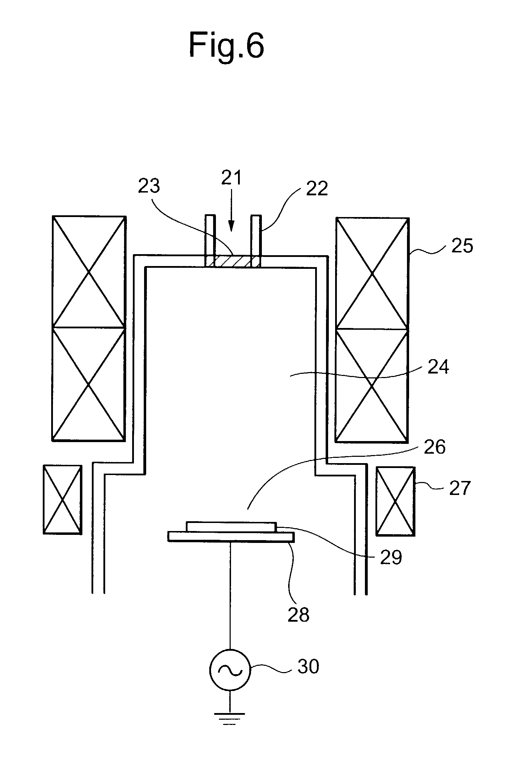

First, an ECR plasma CVD device will be described with reference to Fig. 6 which is a cross sectional side view of the ECR plasma CVD device. Microwave 21 generated from a micro wave source, which is not shown, is transmitted through a waveguide 22 and a microwave transparent window 23 to a plasma generator chamber 24. A main coil 25 is provided outside the plasma generator chamber 24 and an auxiliary coil 27 is provided outside a reaction chamber 26. A sample table 28 for mounting a wafer 29 is provided within the reaction chamber 26 and an RF power source 30 is connected to the sample table 28.

An operational principle of the ECR plasma CVD device will be described briefly.

First, a magnetic field is formed within the plasma generator chamber 24 by supplying a current to the main coil 25. Simultaneously with the introduction of microwave 21 through the waveguide 21 into the plasma generator chamber 24, gas such as O₂ is supplied to the plasma generator chamber 24 through a gas supply system, which is not shown. The gas introduced into the plasma generator chamber 24 resonates with microwave in the magnetic field within the plasma generator chamber 24 and absorbs microwave energy, resulting in high density plasma.

The thus generated plasma is derived from the plasma generator chamber 24 and supplied to the reaction chamber 26 along magnetic lines of force of the magnetic field formed by the main coil 25 and the auxiliary coil 27.

Separately from the gas supply system, gas such as silane (SiH₄) is introduced into the reaction chamber 26 through another gas supply system, which is not shown. Silane reacts with high density plasma resulting in silicon oxide film deposited on the wafer 29 mounted on the sample table 28.

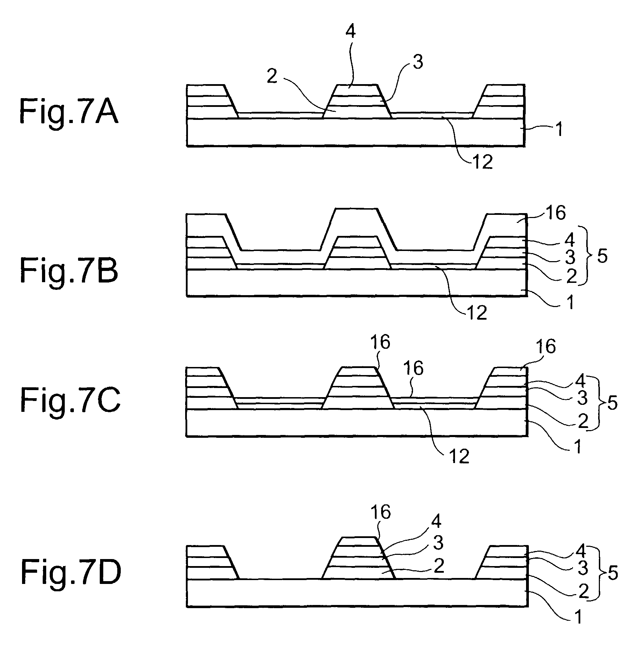

The fabrication method of semiconductor laser in which a silicon oxide film completely covering an upper surface of a mesa structure with using the ECR plasma CVD will be described in detail with reference to Figs. 7A to 7D.

It should be noted that the structure of the semiconductor laser is the same as that shown in Figs. 3 and 4.

As shown in Fig. 7A, a striped silicon oxide mask 12 having growth blocking portions each 5µm wide and opening portions each 1.5µm wide in (011) direction of the n-InP substrate 1 is formed on a (100) plane of an n-InP substrate 1, by patterning a silicon oxide film 1000Å thick Then, the n-InP clad layer 2 (carrier density : 1 x 10¹⁸cm⁻³, film thickness : 150nm), the MQW active layer 3 and the p-InP clad layer 4 (carrier density : 7 x 10¹⁸cm⁻³, film thickness : 150nm) are selectively grown in each of the opening portions of the striped silicon oxide mask 12 in the order by MOVPE, to form the mesa structure, that is, mesa shaped optical waveguide 5.

Then, as shown in Fig. 7B, a silicon oxide film 16 is deposited on the whole surface of the biased n-InP substrate 1 by ECR plasma CVD. In this case, portions of the silicon oxide film 16 deposited on the upper surface of the mesa structure 5, on the sidewall of the mesa structure 5 and on the flat portion of the n-InP substrate 1 are different each other in thickness. That is, the thickness of the silicon oxide film portion deposited on the sidewall of the mesa structure is smallest.

Thereafter, the silicon oxide film 16 is etched by using BHF as etchant. Due to the above mentioned difference of the thickness of the silicon oxide film 16 on the respective portions, the silicon oxide film 16 are left on the upper surface of the mesa structure 5 and on the flat portion of the n-InP substrate 1 as shown in Fig. 7C. The thickness of the silicon oxide film 16 on the side wall of the mesa structure 5 is completely removed by the etching.

Then, as shown in Fig. 7D, the silicon oxide film on the n-InP substrate 1 is removed while leaving the silicon oxide film 16 on the upper surface of the mesa structure 5 through the step similar to that shown in Fig. 5F.

Subsequently thereto, the semiconductor laser shown in Fig. 4 is completed through the step similar to that shown in Fig. 5G.

As mentioned previously, the etching rate of the silicon oxide film 16 deposited on the n-InP substrate 1 while biasing the latter with a certain voltage is high for that on the sidewall of the mesa structure 5 and low for that on the upper surface of the mesa structure 5. Therefore, the thickness of the silicon oxide film deposited on the upper surface of the mesa structure 5 is larger than that deposited on the sidewall of the mesa structure 5. Consequently, when the silicon oxide film 16 is deposited on the substrate while applying a bias voltage thereto, the process margin when the deposited silicon oxide film 16 is etched in the subsequent step with using BHF as etchant becomes large, so that it becomes possible to reliably leave the silicon oxide film on the upper surface of the mesa structure 5.

Although the second embodiment has been described for the case where the silicon oxide film 16 is deposited on the n-InP substrate 1 by using the ECR plasma CVD, it will be clear for those skilled in the art that a similar effect can be obtained by using a plasma CVD with a bias voltage being applied to the substrate.

### [Third Embodiment]

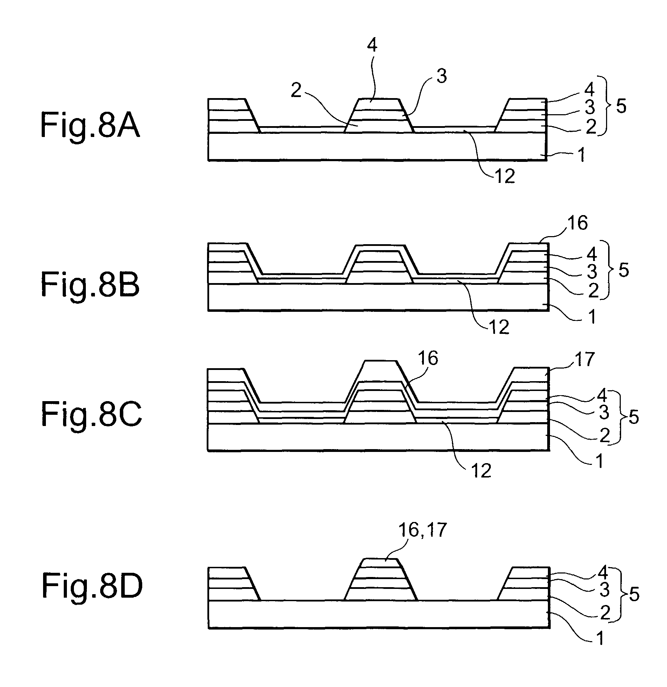

As a third embodiment of the present invention for reliably forming a silicon oxide film completely covering the upper surface of the mesa structure 5, an example in which the ECR plasma CVD is used to deposit the silicon oxide film on an n-InP substrate 1 similarly to the second embodiment will be described with reference to Figs. 8A to 8D. The third embodiment differs from the second embodiment in only that, before the silicon oxide film is deposited on the substrate while a bias voltage being applied thereto, a silicon oxide film is preliminarily deposited on the substrate without biasing.

As shown in Fig. 8A, the mesa structure 5 including the MQW active layer is selectively grown in a similar manner to that shown in Fig. 7A of the second embodiment.

Then, as shown in Fig. 8B, a silicon oxide film 16 is deposited on the whole surface of the n-InP substrate 1 without applying a bias voltage thereto, by using ECR plasma CVD.

Then, as shown in Fig. 8C, a silicon oxide film 17 is deposited on the whole surface of the n-InP substrate 1 while applying a bias voltage thereto, by ECR plasma CVD. In this case, since the etching rate for the silicon oxide film 17 is high on the sidewall of the mesa structure 5 and low on the upper surface of the mesa structure 5, the thickness of the silicon oxide film 17 is large on the upper surface of the mesa structure and small on the sidewall of the mesa structure.

Thereafter, the silicon oxide film on the wafer is etched by using BHF as etchant. Due to the above mentioned difference of the thickness of the silicon oxide film on the respective portions of the n-InP substrate 1, the silicon oxide film 16 is left on the upper surface of the mesa structure 5 and on the flat portion of the n-InP substrate 1. The thickness of the silicon oxide film 16 on the sidewall of the mesa structure 5 is completely removed by the etching.

Then, as shown in Fig. 8D, the silicon oxide film on the n-InP substrate 1 is removed while leaving the silicon oxide film 16 on the upper surface of the mesa structure 5 through the step similar to that shown in Fig 5F.

Subsequently thereto, the semiconductor laser shown in Fig. 4 is completed through the step similar to that shown in Fig. 5G.

According to the third embodiment, it is possible to leave the silicon oxide film on the upper surface of the mesa structure 5 and also to prevent the MQW active layer 3 from being damaged by the etching. It is general that, when the silicon oxide film 17 is directly deposited on the substrate while applying bias voltage thereto, the underlying layer is damaged by etching of the silicon oxide film 17. However, according to this embodiment, damage of the mesa structure 5, particularly the MQW active layer 3 thereof, when the silicon oxide film 17 is etched can be prevented by the silicon oxide film 16 which is preliminarily deposited on the upper surface of the mesa structure 5 without applying bias voltage to the semiconductor substrate.

Although the third embodiment has been described for the case where the silicon oxide film is deposited on the n-InP substrate 1 by using the ECR plasma CVD, it will be clear for those skilled in the art that a similar effect can be obtained by using a plasma CVD with a bias voltage being applied to the substrate.

### [Fourth Embodiment]

As a fourth embodiment of the present invention for reliably forming a silicon oxide film completely covering the upper surface of the mesa structure 5, an example in which the ECR sputtering is used to deposit the silicon oxide film on an n-InP substrate 1 will be described. In the fourth embodiment, a silicon oxide film is deposited on the substrate by applying a bias voltage to the substrate as in the case of the second embodiment. However, the fourth embodiment differs from the second embodiment in that the silicon oxide film is deposited by using the ECR sputtering. Therefore, the fabrication steps according to the fourth embodiment are similar to those of the second embodiment except that the silicon oxide film is deposited on the substrate by using the ECR sputtering. Further, the structure of the semiconductor laser to be formed by the fourth embodiment is similar to that shown in Fig. 4.

When a silicon oxide film 16 is deposited on the whole surface of the n-InP substrate 1 while applying a bias voltage thereto, a portion of ion sputtering the target is directed to the substrate while the silicon oxide film 16 is being deposited and sputters the deposited silicon oxide film 16. Since, as mentioned previously, the etching rate of the silicon oxide film 16 by sputtering is high that on the sidewall of the mesa structure 5 and low for that on the upper surface of the mesa structure 5, the thickness of the silicon oxide film deposited on the upper surface of the mesa structure 5 is larger than that deposited on the sidewall of the mesa structure 5. Consequently, when the silicon oxide film 16 is deposited on the substrate while applying a bias voltage thereto, the process margin when the deposited silicon oxide film 16 is etched in the subsequent step with using BHF as etchant becomes large, so that it becomes possible to reliably leave the silicon oxide film 16 on the upper surface of the mesa structure 5.

Although the fourth embodiment has been described for the case where the silicon oxide film is deposited on the n-InP substrate 1 by using the ECR sputtering, it will be clear for those skilled in the art that a similar effect can be obtained by using a bias-sputtering with a bias voltage being applied to the substrate.

The fourth embodiment is advantageous compared with the first embodiment in that it is possible to deposit the silicon oxide film having thickness larger than that deposited on the side wall of the mesa structure on the upper surface thereof by only one whole surface film forming step.

The reason for this will be described. The ECR sputtering device is user to form, that is, deposit a film on a semiconductor substrate and, when no voltage is applied to the semiconductor substrate, the film is merely deposited thereon. In such case, the difference in depositing rate of the silicon oxide film between the upper surface and the sidewall of the mesa structure is the same as in the case of deposition with using thermal CVD. However, when a voltage is applied to the semiconductor substrate, plasma within the reaction chamber is attracted to the substrate and collides therewith. With the plasma collision, the silicon oxide film once deposited is expelled, causing the sputter-etching phenomenon to occur. The sputter-etching rate for the upper surface of the mesa structure is substantially different from that for the sidewall of the mesa structure, the etching rate for the sidewall of the mesa structure being higher. Therefore, it is possible to deposit the silicon oxide film having thickness larger than that deposited on the sidewall of the mesa structure on the upper surface thereof, while applying a voltage to the substrate.

As above mentioned, it is possible to deposit the silicon oxide film having thickness sufficiently larger than that deposited on the side wall of the mesa structure on the upper surface thereof by only one whole surface film forming step. This is advantageous compared with the first embodiment in which thermal CVD is repeated twice.

### [Fifth Embodiment]

As a fifth embodiment of the present invention for reliably forming a silicon oxide film completely covering the upper surface of the mesa structure 5, another example in which the ECR sputtering is used to deposit the silicon oxide film on an n-InP substrate 1 will be described. In the fifth embodiment, a silicon oxide film is deposited on the substrate without application of a bias voltage to the substrate and, thereafter, a silicon oxide film is further deposited on the substrate while applying the bias voltage thereto, as in the third embodiment. The fifth embodiment differs from the third embodiment in that the silicon oxide film is deposited by using the ECR sputtering. Therefore, the fabrication steps according to the fifth embodiment are similar to those of the third embodiment except that the silicon oxide film is deposited on the substrate by using the ECR sputtering. Further, the structure of the semiconductor laser to be formed by the fifth embodiment is similar to that shown in Fig. 4.

In the fifth embodiment, the silicon oxide film 16 is deposited first without application of the bias voltage to the substrate. Therefore, it is possible to protect the mesa structure 5, particularly, the NQW active layer 3 against the damage caused by the etching of the underlying layer when the silicon oxide film 17 is deposited while applying the bias voltage to the substrate 1.

It will be clear for those skilled in the art that a similar effect can be obtained by the bias-sputtering with a bias voltage being applied to the substrate.

According to the semiconductor laser fabrication method of the present invention, the following effects can be obtained:

In the semiconductor laser fabrication method of the present invention in which the whole surface film forming step for forming the silicon oxide film with using thermal CVD and the whole surface etching step subsequent to the whole surface film forming step are repeated at least twice after the mesa shaped optical waveguide is formed on the semiconductor substrate, the difference in thickness between the silicon oxide film portions formed on the upper surface of the mesa structure, on the sidewall thereof and on the flat portion of the semiconductor substrate is increased. Therefore, it is possible to reliably remove the silicon oxide film on the sidewall of the mesa structure while reliably leaving the silicon oxide film on the upper surface of the mesa structure, by the last whole surface etching step.

Consequently, there is no semiconductor laser element having defective characteristics, which may be caused in the subsequent fabrication step, and the product yield can be improved.

Further, the etching rate of the silicon oxide film deposited on the semiconductor substrate by the plasma CVD including ECR plasma CVD or the bias-sputtering including ECR sputtering while applying a bias voltage to the semiconductor substrate is higher for the silicon oxide film on the sidewall of the mesa structure than that for the upper surface of the mesa structure and the flat portion of the semiconductor substrate, that is, the silicon oxide film deposited on the upper surface of the mesa structure becomes thicker than that deposited on the sidewall of the mesa structure. Therefore, the process margin when the silicon oxide film deposited while applying a bias voltage to the semiconductor substrate is etched with using BHF as etchant is large, so that it is possible to reliably remove the silicon oxide film on the sidewall of the mesa structure while reliably leaving the silicon oxide film on the upper surface of the mesa structure.

Therefore, there is no semiconductor laser element having defective characteristics, which may be caused in the subsequent fabrication step, and the product yield can be improved.

Further, the etching rate of the silicon oxide film deposited on the semiconductor substrate by the plasma CVD including ECR plasma CVD or the bias-sputtering including ECR sputtering without application of a bias voltage to the semiconductor substrate firstly and then with application of the bias voltage secondly is higher for the silicon oxide film on the sidewall of the mesa structure than that for the upper surface of the mesa structure and the flat portion of the semiconductor substrate, that is, the silicon oxide film deposited on the upper surface of the mesa structure becomes thicker than that deposited on the sidewall of the mesa structure. Therefore, the process margin when the silicon oxide film deposited while applying a bias voltage to the semiconductor substrate is etched with using BHF as etchant is large, so that it is possible to reliably remove the silicon oxide film on the sidewall of the mesa structure while reliably leaving the silicon oxide film on the upper surface of the mesa structure.

Therefore, there is no semiconductor laser element having defective characteristics, which may be caused in the subsequent fabrication step, and the product yield can be improved.

Further, in the case where the silicon oxide film is deposited on the semiconductor substrate without application of a bias voltage thereto firstly and then with application of the bias voltage thereto by the plasma CVD including ECR plasma CVD or the bias-sputtering including ECR sputtering secondly, the mesa structure, particularly, the MQW active layer thereof, is protected by the firstly deposited silicon oxide film. There is no damage due to the etching step in depositing the second silicon oxide film with application of the bias voltage to the semiconductor substrate.

Therefore, there is no semiconductor laser element having defective characteristics, which may be caused in the subsequent fabrication step, and the product yield can be improved.

In the described embodiments, silicon oxide films 13, 14, 16, and 17 is formed, however it is not limited to them. It is able to form these films made from the material which prevent the p-block layer 6 and the n-block layer 7 from growing.

It is apparent that the present invention is not limited to the described embodiments, but may be modified and changed without departing from the scope and spirit of the invention.

## Claims

1. A fabrication method for fabricating a semiconductor laser including the step of depositing a insulating film on an upper surface of a mesa shaped optical waveguide formed on a semiconductor substrate, said fabrication method comprising the step of depositing said film such that the thickness of said film on said upper surface of said optical waveguide is larger than the thickness of said film on a side wall of said optical waveguide.

2. A fabrication method as claimed in claim 1, wherein said fabrication method comprises a first step of depositing a film on a whole surface of said semiconductor substrate, a second step of etching a whole surface of said film and a third step of repeating the first and second steps at least twice.

3. A fabrication method as claimed in claim 2, wherein the first step is performed by using thermal CVD.

4. A fabrication method as claimed in claim 3, wherein said film formed by thermal CVD is thicker on said upper surface of said optical waveguide than that on said side wall of said optical waveguide.

5. A fabrication method as claimed in claim 2, wherein the second step is performed by using buffered hydrofluoric acid as an etchant.

6. A fabrication method as claimed in claim 3, wherein the second step is performed by using buffered hydrofluoric acid as an etchant.

7. A fabrication method as claimed in claim 1, wherein the step of depositing said film is performed with application of a bias voltage to said semiconductor substrate under a condition that the deposition of said film and the etching of said film are performed simultaneously.

8. A fabrication method for fabricating a semiconductor laser, as claimed in claim 7, wherein an etching into of said film with the bias voltage being applied to said semiconductor substrate is higher for said film on said upper surface of said optical waveguide formed on said surface of said semiconductor substrate than that for said film on a sidewall of said optical waveguide.

9. A fabrication method for fabricating a semiconductor laser, as claimed in claim 7, wherein said film is thicker on shill upper surface of said optical waveguide than that on said side wall of said optical waveguide.

10. A fabrication method for fabricating a semiconductor laser, as claimed in claim 7, wherein the step of depositing said film comprises a first step of depositing a film without application of a bias voltage to said semiconductor substrate and a second step of further depositing the film while applying the bias to said semiconductor substrate.

11. A fabrication method for fabricating a semiconductor laser, as claimed in claim 7, wherein the step of depositing said film is performed by using plasma CVD.

12. A fabrication method for fabricating a semiconductor laser, as claimed in claim 11, wherein the plasma CVD is ECR plasma CVD.

13. A fabrication method for fabricating a semiconductor laser, as claimed in claim 7, wherein the step of depositing said film is performed by using bias-sputtering.

14. A fabrication method for fabricating a semiconductor laser, as claimed in claim 13, wherein the bias-sputtering is ECR sputtering.

15. A fabrication method for fabricating a semiconductor laser, as claimed in claim 1, wherein said film is a silicon oxide film.
